# EUROPEAN PATENT APPLICATION

(11) **EP 4 839 046 A1**
(43) Date of publication of application: **11.11.2026**
(21) Application number: 26169628.0
(22) Date of filing: 31.03.2026
(51) Int. Cl.: H10D 30/47, H10D 30/01, H10D 30/69, H10D 62/80

(54) **SEMICONDUCTOR DEVICE INCLUDING TWO-DIMENSIONAL MATERIAL AND METHOD OF MANUFACTURING THE SAME**

(30) Priority: 08.05.2025 KR 20250059995
(71) Applicant: Samsung Electronics Co., Ltd., Suwon-si, Gyeonggi-do 16677 (KR)
(72) Inventor: Yoo, Joungeun, 16678 Suwon-si, Gyeonggi-do (KR); Lee, Jongwon, 16677 Suwon-si, Gyeonggi-do (KR); Lee, Eunkyu, 16678 Suwon-si, Gyeonggi-do (KR); Jin, Taewon, 16677 Suwon-si, Gyeonggi-do (KR); Hu, Luhing, 16678 Suwon-si, Gyeonggi-do (KR); Kwon, Junyoung, 16678 Suwon-si, Gyeonggi-do (KR); Kim, Changhyun, 16678 Suwon-si, Gyeonggi-do (KR); Ryu, Huije, 16678 Suwon-si, Gyeonggi-do (KR); Byun, Kyung-Eun, 16678 Suwon-si, Gyeonggi-do (KR); Yoo, Minseok, 16678 Suwon-si, Gyeonggi-do (KR); Lee, Dosun, 16677 Suwon-si, Gyeonggi-do (KR)
(74) Representative: Grünecker Patent- und Rechtsanwälte PartG mbB

(57) **Abstract**

A semiconductor device includes a gate electrode, a gate insulating layer provided on the gate electrode, a channel layer including a two-dimensional material provided on the gate insulating layer, a source electrode and a drain electrode provided on opposite sides of the channel layer, respectively, and a stressor provided in a region in which each of the source electrode and the drain electrode is in contact with the channel layer, and the channel layer is in contact with two or more types of metals by contacting the source electrode, the drain electrode, and the stressor.

## Description

### BACKGROUND

### 1. Field

Some example embodiments of the disclosure relate to semiconductor devices including a two-dimensional material/or and methods of manufacturing the same.

### 2. Description of the Related Art

A transistor is a semiconductor device that performs an electrical switching function and is used in various semiconductor products such as memory and driver integrated circuits (ICs). As the size of semiconductor devices decreases, the number of semiconductor devices that may be integrated into a single wafer increases, and the operating speed of semiconductor devices also increases. Thus, research into reducing the size of semiconductor devices may be advantageous.

Recently, research is being conducted on using a two-dimensional material as a means of reducing the size of semiconductor devices. Two-dimensional materials are attracting attention as a next-generation transistor channel material due to their improved electrical properties and/or atomic-level thickness. However, existing technologies have limitations in that the performance of devices is degraded due to relatively high contact resistance between a metal electrode and a two-dimensional material-channel.

### SUMMARY

Some example embodiments provide semiconductor devices including a two-dimensional material layer and/or methods of manufacturing the semiconductor device.

The invention is what is claimed in the independent claims. Preferred embodiments are specified in the dependent claims.

Additional aspects will be set forth in part in the description which follows and, in part, will be apparent from the description, or may be learned by practice of the presented example embodiments of the disclosure.

According to an example embodiment of the disclosure, a semiconductor device includes a gate electrode, a gate insulating layer on the gate electrode, a channel layer on the gate insulating layer and including a two-dimensional material, a source electrode and a drain electrode on opposite sides of the channel layer, respectively, and a stressor in a region in which each of the source electrode and the drain electrode is in contact with the channel layer, wherein the channel layer is in contact with two or more types of metals by contacting the source electrode, the drain electrode, and the stressor.

The stressor may be in a form of a pattern.

The stressor may be in a form of a droplet.

The stressor may include gold (Au), silver (Ag), or a combination thereof.

The stressor may induce tensile strain in the channel layer.

The stressor may be provided on an upper surface and a side surface of each of the opposite sides of the channel layer.

The stressor may be provided such that the channel layer does not contact the source electrode and the drain electrode.

A thickness of the stressor may be 2 nm or less.

The thickness of the stressor may be 30 nm or less.

Surface energy of the stressor may be greater than or equal to 1.2 J/m².

The two-dimensional material may include transition metal dichalcogenide (TMD), black phosphorus, or graphene.

The TMD may include a transition metal selected from the group including Mo, W, Nb, V, Ta, Ti, Zr, Hf, Tc, Re, Cu, Ga, In, Sn, Ge, and Pb, and a chalcogen element selected from the group including S, Se, and Te.

The TMD may include at least one selected from the group including MoS₂, WS₂, TaS₂, HfS₂, ReS₂, TiS₂, NbS₂, SnS₂, MoSe₂, WSe₂, TaSe₂, HfSe₂, ReSe₂, TiSe₂, NbSe₂, SnSe₂, MoTe₂, WTe₂, TaTe₂, HfTe₂, ReTe₂, TiTe₂, NbTe₂, and SnTe₂.

The source electrode and the drain electrode may each include gold (Au), platinum (Pt), iridium (Ir), rhodium (Rh), ruthenium (Ru), or palladium (Pd).

According to an example embodiment of the disclosure, a method of manufacturing a semiconductor device includes forming a gate electrode on a substrate, depositing a gate insulating layer on the gate electrode, forming a channel layer on the gate insulating layer, forming a stressor on opposite sides of the channel layer, and forming a source electrode and a drain electrode on the opposite sides of the channel layer, respectively, wherein the channel layer is in contact with two or more types of metals.

The stressor may be in a form of a pattern.

The stressor may be in a form of a droplet.

The stressor may include gold (Au), silver (Ag), or a combination thereof.

The stressor may provide tensile strain to the channel layer.

According to an example embodiment of the disclosure, an electronic apparatus includes a memory device, and a memory controller configured to control the memory device, wherein the memory device includes a gate electrode, a gate insulating layer on the gate electrode, a channel layer on the gate insulating layer and including a two-dimensional semiconductor material, a source electrode and a drain electrode on opposite sides of the channel layer, respectively, and a stressor in a region in which each of the source electrode and the drain electrode is in contact with the channel layer, wherein the channel layer is in contact with two or more types of metals.

The stressor may be in a form of a pattern.

The stressor may be in a form of a droplet.

The stressor may provide tensile strain to the channel layer.

### BRIEF DESCRIPTION OF THE DRAWINGS

The above and other aspects, features, and advantages of certain example embodiments of the disclosure will be more apparent from the following description taken in conjunction with the accompanying drawings, in which:
FIG. 1 is a diagram illustrating a semiconductor device according to an example embodiment;
FIG. 2 is a diagram illustrating a semiconductor device according to an example embodiment;
FIG. 3 is a diagram illustrating a semiconductor device according to an example embodiment;
FIGS. 4 and 5 are graphs showing characteristics of a semiconductor device according to an example embodiment;
FIG. 6 is a graph showing the characteristics of a semiconductor device according to an example embodiment;
FIG. 7 is a graph showing the characteristics of a semiconductor device according to an example embodiment;
FIG. 8 is a graph showing the characteristics of a semiconductor device according to an example embodiment;
FIG. 9A is a graph showing a Raman spectrum of an example embodiment;
FIG. 9B is an enlarged view of a portion of the graph of FIG. 9A;
FIGS. 10A and 10B are Atomic Force Microscope (AFM) images of an example embodiment.
FIG. 11A is a graph showing a Raman spectrum of an example embodiment;
FIG. 11B is an enlarged view of a portion of the graph of FIG. 11A;
FIG. 12 is a flowchart illustrating a method of manufacturing a semiconductor device, according to an example embodiment; and
FIGS. 13 and 14 are conceptual diagrams schematically showing electronic component architectures that may be applied to an electronic device, according to some example embodiments.

### DETAILED DESCRIPTION

Reference will now be made in detail to example embodiments, examples of which are illustrated in the accompanying drawings, wherein like reference numerals refer to like elements throughout. In this regard, the present example embodiments may have different forms and should not be construed as being limited to the descriptions set forth herein. Accordingly, the example embodiments are merely described below, by referring to the figures, to explain aspects. As used herein, the term "and/or" includes any and all combinations of one or more of the associated listed items. Expressions such as "one of," "one or more of," "any one of," "at least one of," and "at least one selected from" when preceding a list of elements, modify the entire list of elements and do not modify the individual elements of the list. Thus, for example, both "at least one of A, B, or C" and "at least one of A, B, and C" mean either A, B, C or any combination thereof. Likewise, A and/or B means A, B, or A and B.

While the term "same," "equal" or "identical" is used in description of example embodiments, it should be understood that some imprecisions may exist. Thus, when one element is referred to as being the same as another element, it should be understood that an element or a value is the same as another element within a desired manufacturing or operational tolerance range (e.g., ±10%).

When the term "about," "substantially" or "approximately" is used in this specification in connection with a numerical value, it is intended that the associated numerical value includes a manufacturing or operational tolerance (e.g., ±10%) around the stated numerical value. Moreover, when the word "about," "substantially" or "approximately" is used in connection with geometric shapes, it is intended that precision of the geometric shape is not required but that latitude for the shape is within the scope of the disclosure. Further, regardless of whether numerical values or shapes are modified as "about" or "substantially," it will be understood that these values and shapes should be construed as including a manufacturing or operational tolerance (e.g., ±10%) around the stated numerical values or shapes.

Hereinafter, with reference to the attached drawings, semiconductor devices including a two-dimensional material according to various example embodiments and/or methods of manufacturing the same will be described in detail. In the following drawings, the same reference numerals refer to the same components, and the size of each component in the drawings may be exaggerated for clarity and convenience of explanation. Also, the example embodiments described herein may have different forms and should not be construed as being limited to the descriptions set forth herein.

It will also be understood that when an element is referred to as being "on" or "above" another element, the element may be in direct contact with the other element or other intervening elements may be present. The singular forms include the plural forms unless the context clearly indicates otherwise. It should be understood that, when a part "comprises" or "includes" an element in the specification, unless otherwise defined, other elements are not excluded from the part and the part may further include other elements.

The use of the terms "a", "an", and "the" and similar referents are to be construed to cover both the singular and the plural. The steps of all methods described herein may be performed in any suitable order unless otherwise indicated herein or otherwise clearly contradicted by context.

The connecting lines, or connectors illustrated in the various figures presented are intended to represent example functional relationships and/or physical or logical couplings between the various elements. It should be noted that many alternative or additional functional relationships, physical connections or logical connections may be present in a practical device.

The use of any and all examples, or example language (e.g., "such as") provided herein, is intended merely to better illuminate the disclosure and does not pose a limitation on the scope of the disclosure unless otherwise claimed.

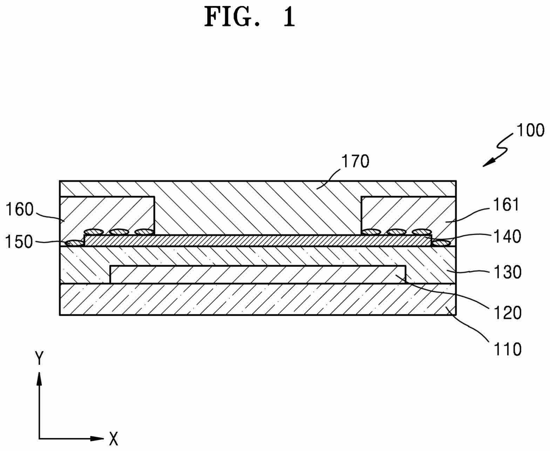

FIG. 1 is a diagram illustrating a semiconductor device according to an example embodiment. A semiconductor device 100 illustrated in FIG. 1 may include, for example, a field effect transistor (FET).

Referring to FIG. 1, the semiconductor device 100 may include a substrate 110, a gate electrode 120 provided on the substrate 110, a gate insulating layer 130 provided on the gate electrode 120, a channel layer 140 provided on the gate insulating layer 130 and including a two-dimensional material, a source electrode 160 and a drain electrode 161 provided on opposite sides of the channel layer 140, and a stressor 150 provided in a region in which the source electrode 160 and the drain electrode 161 are in contact with the channel layer 140.

The substrate 110 may be an insulating substrate, or may be a semiconductor substrate having an insulating layer formed on a surface thereof. The semiconductor substrate may include, for example, Si, Ge, SiGe, or a Group III-V semiconductor material. The substrate 110 may be, for example, a silicon substrate having silicon oxide formed on a surface thereof, but is not limited thereto.

The gate electrode 120 may include metal, conductive nitride, or conductive oxide. The metal may include, for example, at least one of Au, Ti, W, Mo, Pt or Ni. The conductive nitride may include, for example, TiN, TaN, WN, etc., and the conductive oxide may include, for example, indium tin oxide (ITO), indium zinc oxide (IZO), etc. However, this is merely an example.

The gate insulating layer 130 may include an insulating material. The gate insulating layer 130 may include, for example, silicon nitride, but is not limited thereto.

The channel layer 140 may be a single layer or may include a plurality of layers. The channel layer 140 may include a two-dimensional material. The two-dimensional material may include transition metal dichalcogenide (TMD), black phosphorus, graphene, or phosphorene. The TMD may include a transition metal selected from the group including Mo, W, Nb, V, Ta, Ti, Zr, Hf, Tc, Re, Cu, Ga, In, Sn, Ge, and Pb, and a chalcogen element selected from the group including S, Se, and Te. The TMD may include at least one selected from the group including, for example, MoS₂, WS₂, TaS₂, HfS₂, ReS₂, TiS₂, NbS₂, SnS₂, MoSe₂, WSe₂, TaSe₂, HfSe₂, ReSe₂, TiSe₂, NbSe₂, SnSe₂, MoTe₂, WTe₂, TaTe₂, HfTe₂, ReTe₂, TiTe₂, NbTe₂, and SnTe₂.

The source electrode 160 and the drain electrode 161 may be provided on the opposite sides of the channel layer 140 and spaced apart from each other. The source electrode 160 and the drain electrode 161 may each include, for example, gold (Au), platinum (Pt), iridium (Ir), rhodium (Rh), ruthenium (Ru), or palladium (Pd).

The stressor 150 may be provided in a contact area in which each of the source electrode 160 and the drain electrode 161 are in contact with the channel layer 140. The stressor 150 may be provided on an upper surface and a side surface of the opposite sides of the channel layer 140.

The stressor 150 may be a material layer that induces strain in an adjacent area thereof. The stressor 150 may induce tensile strain in the channel layer 140. The stressor 150 may induce tensile strain in the contact area in which the channel layer 140 is in contact with each of the source electrode 160 and the drain electrode 161. As the stressor 150 induces tensile strain in the channel layer 140, the contact resistance between the channel layer 140 and the source electrode 160 and the contact resistance between the channel layer 140 and the drain electrode 161 may be reduced.

The stressor 150 may include metal. The stressor 150 may include metal having a relatively large difference in thermal expansion coefficient from a material forming the channel layer 140. The stressor 150 may include metal having a relatively high adhesion energy with the material forming the channel layer 140. Surface energy of the stressor 150 may be greater than or equal to 1.2 J/m². The stressor 150 may include gold (Au), silver (Ag), or a combination thereof. The thermal expansion coefficient of silver (Ag) is about 14.2E-6/K, adhesion energy of silver (Ag) with MoS₂ is about -1.14 eV, and surface energy of silver (Ag) is about 1.2 J/m². The thermal expansion coefficient of gold (Au) is approximately 19.7E-6/K, adhesion energy of gold (Au) with MoS₂ is approximately -1.11 eV, and surface energy of gold (Au) is approximately 1.5 J/m².

The stressor 150 may be in the form of a pattern. The stressor 150 may include a pattern shape to control the degree of strain. The stressor 150 including a pattern shape indicates that the stressor 150 is locally provided between the channel layer 140 and the source electrode 160 or the drain electrode 161, regardless of the specific shape of the stressor 150. As the stressor 150 includes a pattern shape, the channel layer 140 not only comes into contact with the stressor 150, but also comes into contact with the source electrode 160 and the drain electrode 161, and thus, the channel layer 140 may come into contact with two or more types of metals.

The stressor 150 may be in the form of a droplet. A plurality of stressors 150 may be provided in the form of droplets. As the plurality of stressors 150 are provided in the form of droplets and spaced apart from each other, a space may be formed between the stressors 150, and this space may be filled with the same metal as the metal forming the source electrode 160 and the drain electrode 161. Accordingly, the channel layer 140 not only comes into contact with the stressor 150, but also comes into contact with the source electrode 160 and the drain electrode 161, and thus, the channel layer 140 may come into contact with two or more types of metals.

The semiconductor device 100 of FIG. 1 is illustrated as a bottom gate structure in which the gate electrode 120 is located at the bottom thereof, but is not limited thereto and may have a top gate structure in which the gate electrode 120 is located at the top thereof.

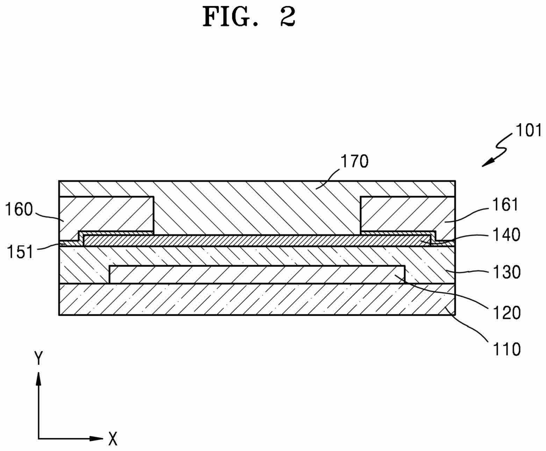

FIG. 2 is a diagram illustrating a semiconductor device according to an example embodiment. A semiconductor device 101 illustrated in FIG. 2 may include, for example, a FET.

Referring to FIG. 2, the semiconductor device 100 may include the substrate 110, the gate electrode 120 provided on the substrate 110, the gate insulating layer 130 provided on the gate electrode 120, the channel layer 140 provided on the gate insulating layer 130 and including a two-dimensional material, the source electrode 160 and the drain electrode 161 provided on the opposite sides of the channel layer 140, and a stressor 151 provided in a region in which each of the source electrode 160 and the drain electrode 161 are in contact with the channel layer 140.

The stressor 151 may be provided in the form of a single layer such that the channel layer 140 does not contact the source electrode 160 and the drain electrode 161. A thickness of the stressor 151 may be relatively small. The thickness of the stressor 151 may be, for example, greater than about 0 nm and equal to or less than about 2 nm. The semiconductor device 101 may be identical to the semiconductor device 100 of FIG. 1, except that the stressor 151 may be provided in the form of a single layer such that the channel layer 140 does not contact the source electrode 160 and the drain electrode 161. In the description with reference to FIG. 2, repeated description overlapping with that of FIG. 1 is omitted.

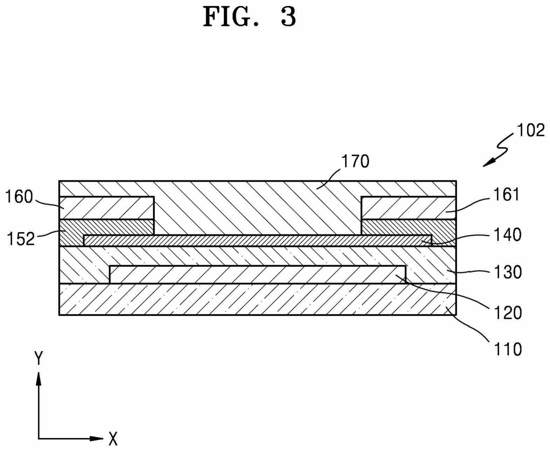

FIG. 3 is a diagram illustrating a semiconductor device according to an example embodiment.

Referring to FIG. 3, a semiconductor device 102 may include the substrate 110, the gate electrode 120 provided on the substrate 110, the gate insulating layer 130 provided on the gate electrode 120, the channel layer 140 provided on the gate insulating layer 130 and including a two-dimensional material, the source electrode 160 and the drain electrode 161 provided on the opposite sides of the channel layer 140, and a stressor 152 provided in a region in which each of the source electrode 160 and the drain electrode 161 are in contact with the channel layer 140.

The stressor 152 may be provided in the form of a single layer such that the channel layer 140 does not contact the source electrode 160 and the drain electrode 161. A thickness of the stressor 152 may be relatively great. The thickness of the stressor 152 may be, for example, greater than about 2 nm and equal to and less than about 30 nm. The thickness of the stressor 152 may be, for example, about 10 nm to about 30 nm. The semiconductor device 102 may be identical to the semiconductor device 100 of FIG. 1, except that the stressor 152 may be provided in the form of a single layer such that the channel layer 140 does not contact the source electrode 160 and the drain electrode 161. In the description with reference to FIG. 3, repeated description overlapping with that of FIG. 1 is omitted.

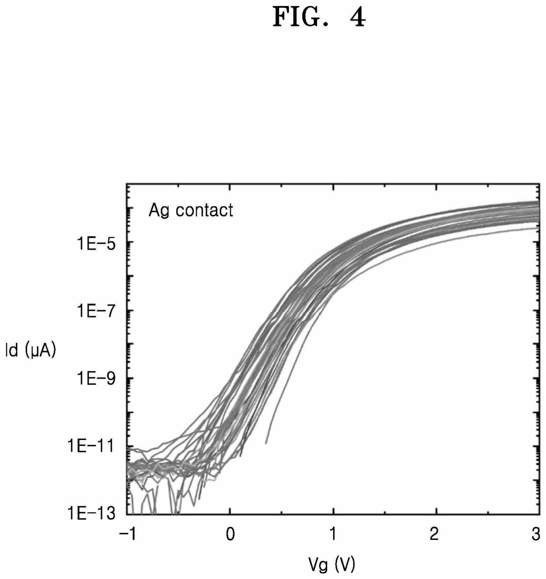

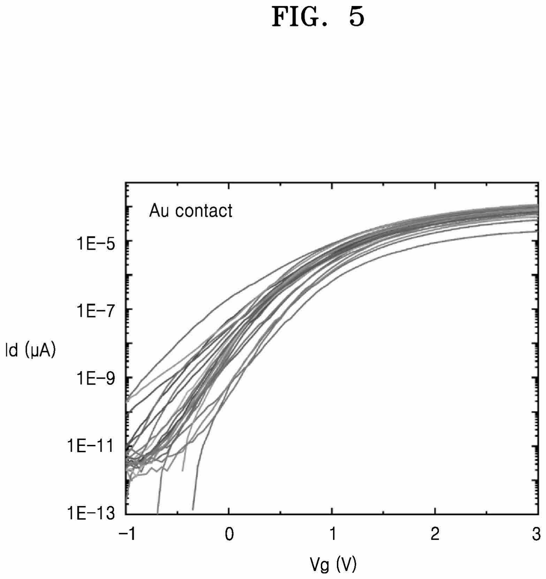

FIGS. 4 and 5 are graphs showing characteristics of a semiconductor device according to an example embodiment.

FIG. 4 is a graph showing a relationship between a gate voltage and a drain current of a semiconductor device including a stressor including silver (Ag) and a channel layer including MoS₂, and FIG. 5 is a graph showing a relationship between a gate voltage V_{g} and a drain current I_{d} of a semiconductor device including a stressor including gold (Au) and a channel layer including MoS₂.

Referring to FIGS. 4 and 5, it may be seen that both graphs have low drain current values when the gate voltage is 0, indicating that the leakage current is relatively small. However, it may be confirmed that the leakage current of the semiconductor device of FIG. 4, which includes silver (Ag) as the stressor (Ag contact), is less than that of the semiconductor device of FIG. 5, which includes gold (Au) as the stressor (Au contact).

This indicates that, as silver (Ag) induces more tensile strain at the interface with the channel layer including MoS₂ than gold (Au), when the semiconductor device includes a stressor including silver (Ag), the leakage current characteristics are improved compared to when the semiconductor device includes a stressor including gold (Au), and better performance of the semiconductor device is achieved.

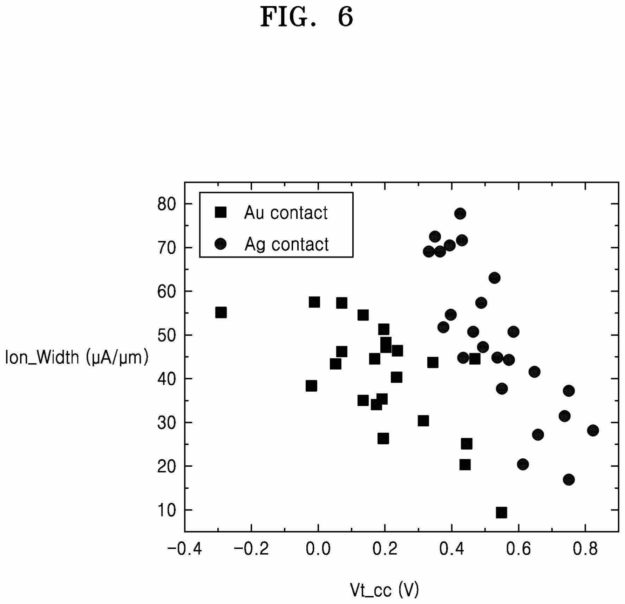

FIG. 6 is a graph showing the characteristics of a semiconductor device according to an example embodiment.

Referring to FIG. 6, it may be seen that a semiconductor device including silver (Ag) as a stressor (Ag contact) has a higher threshold voltage value than a semiconductor device including gold (Au) as a stressor (Au contact).

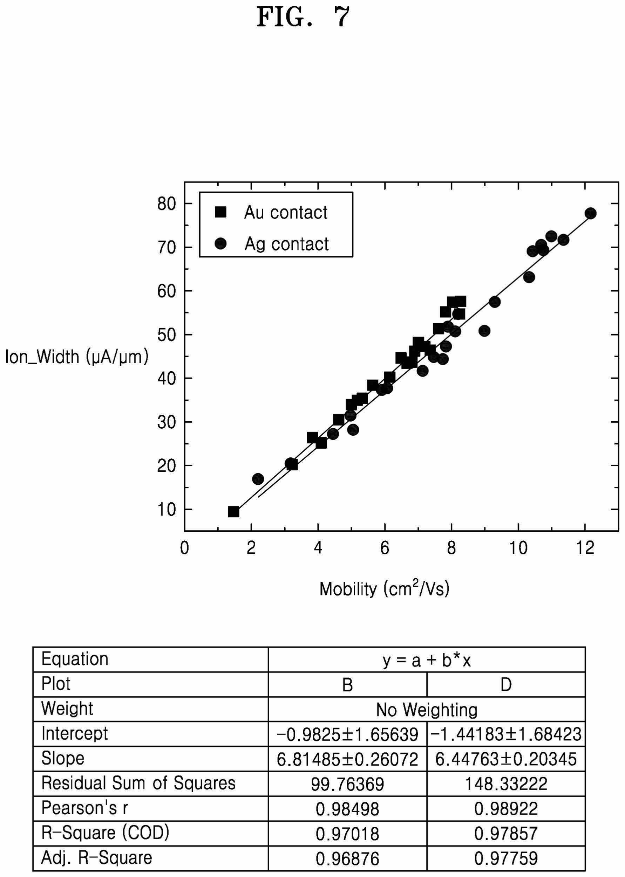

FIG. 7 is a graph showing the characteristics of a semiconductor device according to an example embodiment.

Referring to FIG. 7, it may be seen that the increase rate of Iₒₙ according to mobility, as indicated by a slope of the graph above, does not show a significant difference (e.g., a difference greater than a threshold value) between the semiconductor device including silver (Ag) as a stressor (Ag contact) and the semiconductor device including gold (Au) as a stressor (Au contact).

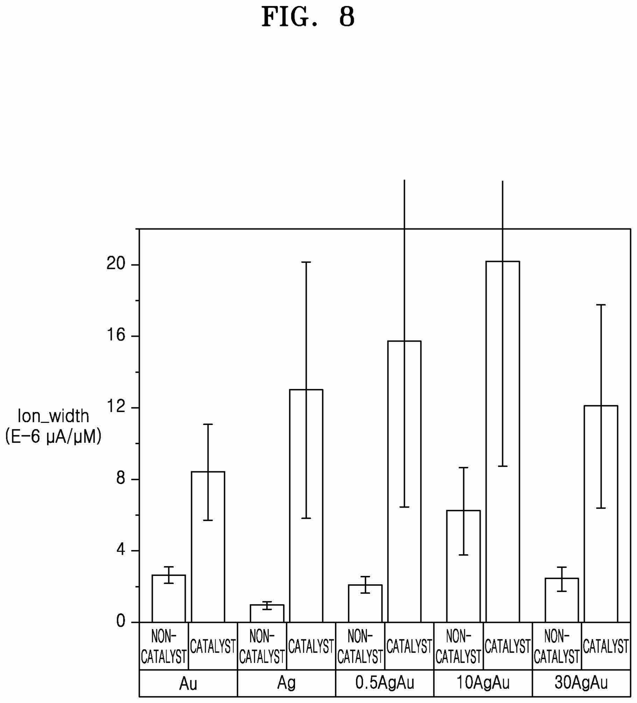

FIG. 8 is a graph showing the characteristics of a semiconductor device according to an example embodiment.

Referring to FIG. 8, it may be seen that when a catalyst is used, the semiconductor device including silver (Ag) as a stressor has a higher Iₒₙ value than the semiconductor device including gold (Au) as a stressor.

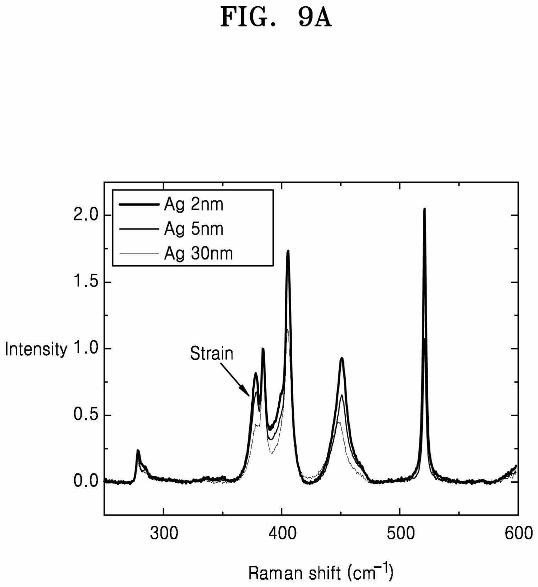

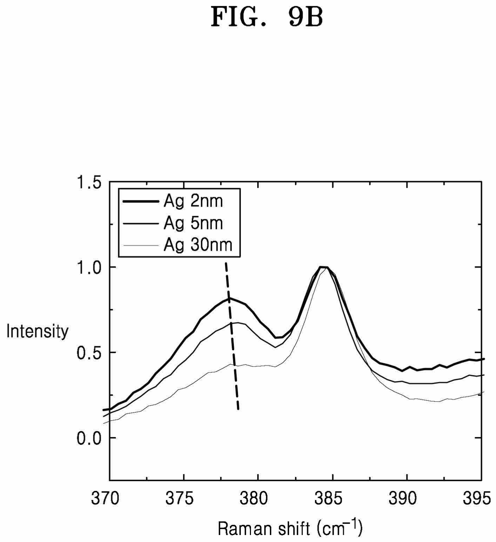

FIG. 9A is a graph showing a Raman spectrum of an example embodiment, and FIG. 9B is an enlarged view of a portion of the graph of FIG. 9A.

FIG. 9A is a graph showing Raman spectra for three examples including Ag, with different thicknesses (2 nm, 5 nm, 30 nm) on MoS₂, and FIG. 9B is an enlarged view of strain peaks of the Raman spectra.

Referring to FIGS. 9A and 9B, as the thickness of Ag provided on MoS₂ decreases to 30 nm, 5 nm, and 2 nm, the intensity of the Raman spectrum has a higher value. Through this, it may be confirmed that the thinner the thickness of Ag, the more strain is applied to MoS₂.

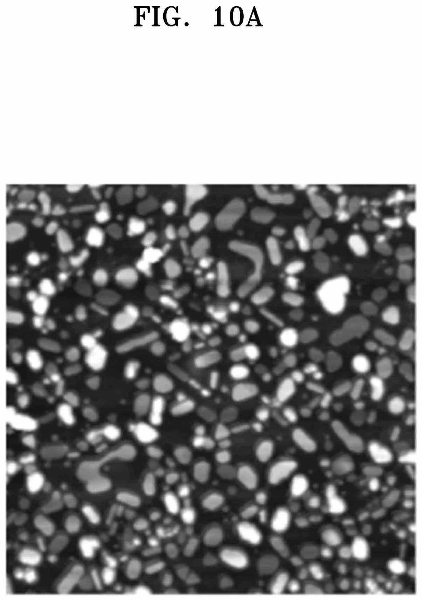

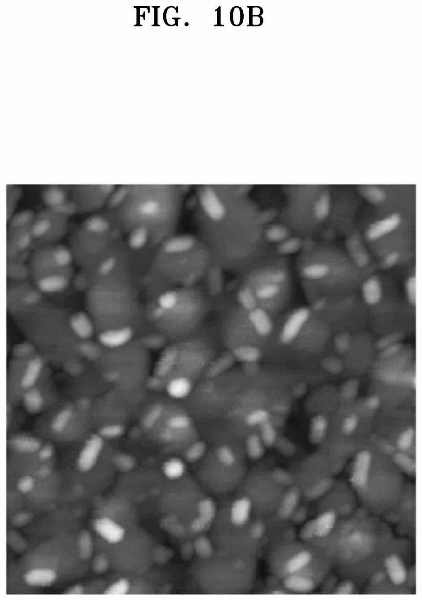

FIGS. 10A and 10B are Atomic Force Microscope (AFM) images of an example embodiment.

FIG. 10A is a diagram illustrating an AFM image when the thickness of Ag provided on MoS₂ is 2 nm, and FIG. 10B is a diagram illustrating an AFM image when the thickness of Ag provided on MoS₂ is 30 nm.

Referring to FIG. 10A and FIG. 10B, when the thickness of Ag provided on MoS₂ is 2 nm, more droplets are distributed than when the thickness of Ag provided on MoS₂ is 30 nm, and through this, it may be confirmed that the thinner the thickness of Ag, the more strain is applied to MoS₂.

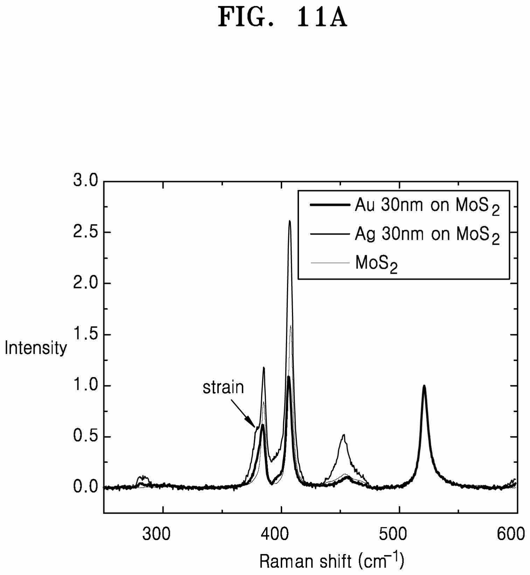

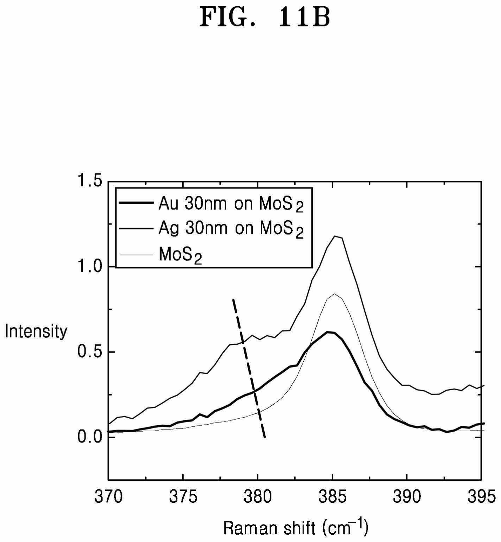

FIG. 11A is a graph showing a Raman spectrum of an example embodiment, and FIG. 11B is an enlarged view of a portion of the graph of FIG. 11A.

Specifically, FIG. 11A is a graph showing Raman spectra for an example in which Ag is provided on MoS₂, with a thickness of 30 nm and an example in which Au is provided on MoS₂, with a thickness of 30 nm, and FIG. 11B is a diagram in which a strain peak of the Raman spectrum is enlarged.

Referring to FIGS. 11A and 11B, it may be seen that in both the case where Au is provided on MoS₂, with a thickness of 30 nm and in the case where Ag is provided on MoS₂, with a thickness of 30 nm, the intensity of the Raman spectrum is higher than in the case where only MoS₂ is present, and in the case where Ag is provided on MoS₂, with a thickness of 30 nm, the intensity of the Raman spectrum is higher than in the case where Au is provided on MoS₂, with a thickness of 30 nm. This indicates that a greater strain is applied to MoS₂ when Ag is provided than when Au is provided.

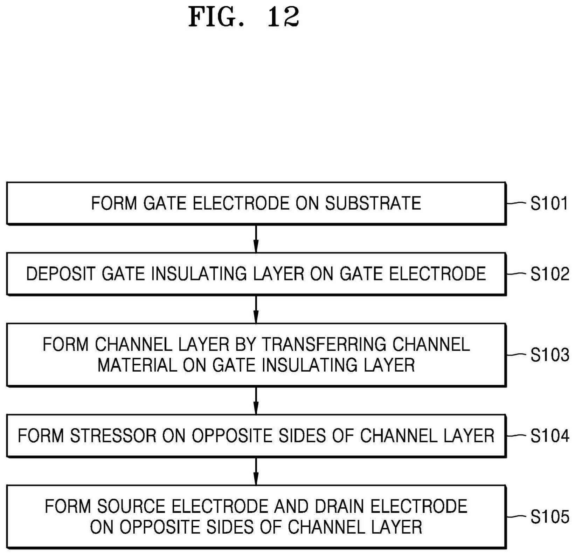

FIG. 12 is a flowchart illustrating a method of manufacturing a semiconductor device, according to an example embodiment.

Referring to FIG. 12, a gate electrode is formed on a substrate (S101), and a gate insulating layer is deposited on the gate electrode (S102). The gate insulating layer may include an insulating material. A channel layer may be formed by transferring a channel material to the gate insulating layer (S103). The channel layer may include a two-dimensional material. The gate insulation layer and the channel layer may be performed by chemical vapor deposition (CVD), physical vapor deposition (PVD), or atomic layer deposition (ALD) processes, or a combination thereof.

A stressor may be formed on opposite sides of the channel layer (S104). Additionally, a source electrode and a drain electrode may be formed on the opposite sides of the channel layer (S105). A method of manufacturing a semiconductor device, according to an example embodiment, may be applied.

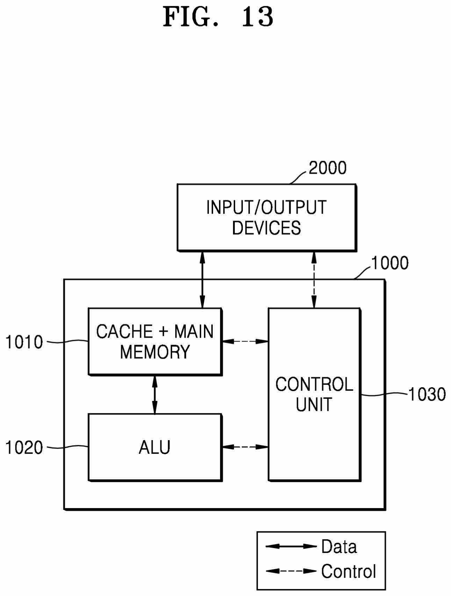

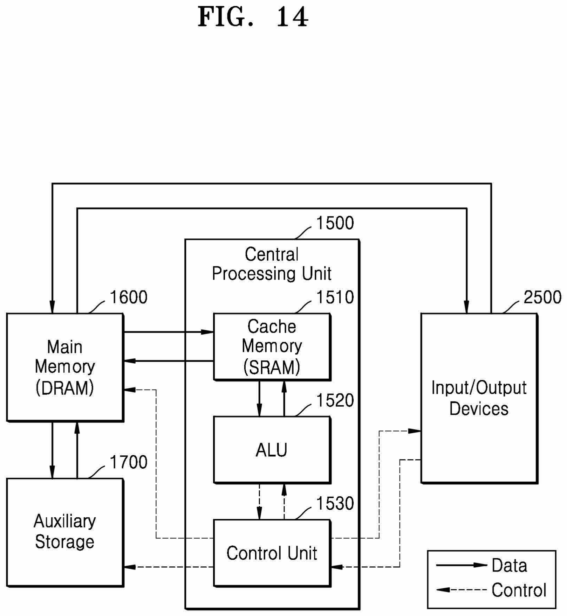

FIGS. 13 and 14 are conceptual diagrams schematically illustrating electronic component architectures that may be applied to an electronic device, according to some example embodiments.

Referring to FIG. 13, an electronic component architecture 1000 may include a memory unit 1010, an arithmetic logic unit (ALU) 1020, and a control unit 1030. The memory unit 1010, the ALU 1020, and the control unit 1030 may be electrically connected to each other. For example, the electronic component architecture 1000 may be implemented as a single chip including the memory unit 1010, the ALU 1020, and the control unit 1030.

The memory unit 1010, the ALU 1020, and the control unit 1030 may be interconnected on-chip via metal lines and communicate directly with each other. The memory unit 1010, the ALU 1020, and the control unit 1030 may be monolithically integrated on a single substrate to form a chip. The electronic component architecture 1000 may have input/output devices 2000 connected thereto.

The ALU 1020 and the control unit 1030 may each independently include the semiconductor device 100, 101, or 102, and the memory unit 1010 may include the semiconductor device 100, 101, or 102, a capacitor, or a combination thereof. The memory unit 1010 may include both main memory and cache memory. The electronic component architecture 1000 may be an on-chip memory processing unit.

Referring to FIG. 14, a cache memory 1510, an ALU 1520, and a control unit 1530 may constitute a central processing unit (CPU) 1500. The cache memory 1510 may include static random-access memory (SRAM) and include the semiconductor device 100, 101, or 102 described above. Separately from the CPU 1500, the main memory 1600 and the auxiliary storage 1700 may be provided. The main memory 1600 may include a dynamic random-access memory (DRAM) device.

In some cases, the electronic component architecture 1000 may be implemented in a single chip with computing units and memory units adjacent to each other, without distinction between sub-units.

Any functional blocks shown in the figures and described above may be implemented in processing circuitry such as hardware including logic circuits, a hardware/software combination such as a processor executing software, or a combination thereof. For example, the processing circuitry more specifically may include, but is not limited to, a central processing unit (CPU), an arithmetic logic unit (ALU), a digital signal processor, a microcomputer, a field programmable gate array (FPGA), a System-on-Chip (SoC), a programmable logic unit, a microprocessor, application-specific integrated circuit (ASIC), etc.

According to some example embodiments of the disclosure, semiconductor devices including a two-dimensional material layer and having a reduced contact resistance between a metal electrode and a two-dimensional channel and/or manufacturing methods thereof may be provided. The semiconductor devices including a two-dimensional material and the methods of manufacturing the semiconductor device have been described with reference to the example embodiments shown in the drawings, but these are merely examples, and it will be obvious to those skilled in the art that various modifications and equivalents may be made therefrom. The disclosed example embodiments should be considered in a descriptive sense only and not for purposes of limitation. The scope of the disclosure is defined not by the detailed description of the disclosure but by the appended claims, and all differences within the scope will be construed as being included in the disclosure.

According to some example embodiments of the disclosure, semiconductor devices having reduced contact resistance between a metal electrode and a two-dimensional channel and/or methods of manufacturing the semiconductor device are provided.

It should be understood that the example embodiments described herein should be considered in a descriptive sense only and not for purposes of limitation. Descriptions of features or aspects within each example embodiment should typically be considered as available for other similar features or aspects in other example embodiments. While one or more example embodiments have been described with reference to the figures, it will be understood by those of ordinary skill in the art that various changes in form and details may be made therein without departing from the scope as defined by the following claims.

## Claims

1. A semiconductor device comprising:
a gate electrode;
a gate insulating layer on the gate electrode;
a channel layer on the gate insulating layer and including a two-dimensional material;
a source electrode and a drain electrode on opposite sides of the channel layer, respectively; and
a stressor in a region in which each of the source electrode and the drain electrode is in contact with the channel layer,
wherein the channel layer is in contact with two or more types of metals by contacting the source electrode, the drain electrode, and the stressor.

2. The semiconductor device of claim 1, wherein the stressor is either in a form of a pattern or in a form of a droplet.

3. The semiconductor device of claim 1, wherein the stressor comprises gold, Au, silver, Ag, or a combination thereof.

4. The semiconductor device of one of claims 1 to 3, wherein the stressor induces tensile strain in the channel layer.

5. The semiconductor device of one of claims 1 to 3, wherein the stressor is on an upper surface and a side surface of each of the opposite sides of the channel layer.

6. The semiconductor device of one of claims 1 to 5, wherein the stressor is provided such that the channel layer does not contact the source electrode and the drain electrode.

7. The semiconductor device of claim 6, wherein a thickness of the stressor is 2 nm or less, or
wherein a thickness of the stressor is 30 nm or less.

8. The semiconductor device of one of claims 1 to 7, wherein surface energy of the stressor is greater than or equal to 1.2 J/m².

9. The semiconductor device of one of claims 1 to 8, wherein the two-dimensional material comprises transition metal dichalcogenide, TMD, black phosphorus, or graphene.

10. The semiconductor device of claim 9, wherein the TMD comprises a transition metal selected from the group including Mo, W, Nb, V, Ta, Ti, Zr, Hf, Tc, Re, Cu, Ga, In, Sn, Ge, and Pb, and a chalcogen element selected from the group including S, Se, and Te, and
wherein the TMD preferably comprises at least one selected from the group including MoS₂, WS₂, TaS₂, HfS₂, ReS₂, TiS₂, NbS₂, SnS₂, MoSe₂, WSe₂, TaSe₂, HfSe₂, ReSe₂, TiSe₂, NbSe₂, SnSe₂, MoTe₂, WTe₂, TaTe₂, HfTe₂, ReTe₂, TiTe₂, NbTe₂, and SnTe₂.

11. The semiconductor device of one of claims 1 to 10, wherein the source electrode and the drain electrode each comprise gold, Au, platinum, Pt, iridium, Ir, rhodium, Rh, ruthenium, Ru, or palladium, Pd.

12. A method of manufacturing a semiconductor device, the method comprising:
forming a gate electrode on a substrate;
depositing a gate insulating layer on the gate electrode;
forming a channel layer on the gate insulating layer;
forming a stressor on opposite sides of the channel layer; and
forming a source electrode and a drain electrode on the opposite sides of the channel layer, respectively,
wherein the channel layer is in contact with two or more types of metals.

13. The method of claim 12, wherein the stressor is either in a form of a pattern or in a form of a droplet.

14. The method of claim 12, wherein the stressor comprises gold, Au, silver, Ag, or a combination thereof, or
wherein the stressor provides tensile strain to the channel layer.

15. An electronic apparatus comprising:
a memory device; and
a memory controller configured to control the memory device,
wherein the memory device is a semiconductor device according to one of claims 1 to 11.
